# EUROPEAN PATENT SPECIFICATION

(11) **EP 1 701 358 B1**
(45) Date of publication and mention of the grant of the patent: **21.01.2009**
(21) Application number: 04802459.0
(22) Date of filing: 14.12.2004
(51) Int. Cl.: G11C 16/08

(54) **DATA WRITE-IN METHOD FOR FLASH MEMORY**
DATENEINSCHREIBEVERFAHREN FÜR FLASH-SPEICHER
PROCEDE D'ENREGISTREMENT DE DONNEES DANS UNE MEMOIRE FLASH

(30) Priority: 31.12.2003 CN 200310117714
(43) Date of publication of application: 13.09.2006
(73) Proprietor: Netac Technology Co., Ltd., Shenzhen, Guangdong 518057 (CN)
(72) Inventor: XIONG, G., c/o China Academy Science & Tech Dev., Nanshan Dist, Shenzhen, Guangdong 518057 (CN)
(74) Representative: Ebner von Eschenbach, Jennifer
(86) International application number: PCT/CN2004/001446
(87) International publication number: WO 2005/064617

(56) References cited:
- CN-A- 1 362 708
- JP-A- 2003 085 039
- JP-A- 2003 132 687
- US-A- 5 648 929

## Description

### Field

The present invention relates to a data write-in method for flash memory, and more particularly, to a method for writing data into two or more flash chips.

### Background

Presently, flash chips have been widely used in mobile storage apparatuses. However, the operating speed of such mobile storage apparatuses is slow due to the defects existing in the intrinsic characteristics and the existing data operating method of flash chips. The storage space of each flash chip (simply referred to as flash chip) is generally divided into multiple blocks (i.e., physical blocks), each composed of multiple pages. According to the read-write characteristics of flash chips, the data write-in operation is performed in a unit of page, while the erase operation can only be performed in a unit of block. Thus, when new data is being written into flash chips or existing data is being modified according to user operations, the old data on the target block (known as "original block" pointed by data writing instruction) must firstly be conveyed to another block (known as "new block"). The new data will then be written on the new block and data on the old block will be erased. Finally, the logic address of the new block will replace the one of the old block. During the whole process, writing and erasing operations are the most time consuming.

The current process of writing operation of flash chips is: 1) writing programming, 2) waiting for the completion of the writing programming, 3) performing the erase operation after the completion of the writing programming, and 4) carrying over the next writing programming again. This method is necessary for one flash chip (the "one" chip described herein is corresponding to one chip select signal; if there are two chip select signals, it is considered as "two" flash chips). Since there is only one chip select signal on one flash chip, two different operations (i.e., programming) cannot be performed simultaneously. However, as for a storage device containing multiple flash chips, the writing operation speed of flash chips may be severely limited if data write-in operation is performed according to the writing operation process described above. Presently, with the increase of the capacity of mobile storage devices, it is an inevitable trend to employ multiple flash chips. Therefore, increase the write-in speed of flash chips becomes crucial in flash memory technology. To improve the operating speed of flash memory card, a method for simultaneously performing block erase operation in at least two flash chips has been known in US 5648929.

Therein, flash chips ("device pairs" D1,D2) are partitioned into physical blocks ("block pairs" PB1,PB2), and corresponding physical blocks (PB1) in succeeding flash chips (D1,D2,D3,..) are mapped into a sequence of logical blocks ("logic block pairs" LB1,LB2,..). Since memory operations mostly relate to succeeding logical addresses, such operations are directed to different flash chips such that a next operation may be initiated already during the execution of the preceding operation.

### Summary

The object of the present invention is to provide a data write-in method for flash memory. This method will be rid of the disadvantages of the current flash chips data operating technology, such as low operating speed and low efficiency. The data write-in method for flash memory of the present invention is implemented by the following technical schemes.

The method comprises: a. partitioning the physical blocks in the two flash chips to odd logical block addresses and even logical block addresses, respectively; b. receiving a data write-in instruction and analyzing the beginning logical address corresponding to the writing operation from the data write-in instruction; c. obtaining according to the beginning logical address the logical block address needed to be written, deciding the parity of the logical block address needed to be written, and selecting the corresponding flash chip between the two flash chips according to the parity of the logical block address needed to be written; d. detecting whether the other flash chip needs to be programmed or erased after the programming or erase instruction is directed to the physical block corresponding to the logical block address in the corresponding flash chip. Finally the programming or erase instruction, if needed, are applied to the other flash chip.

The methods of the present invention make it possible to program or erase one flash chip while programming or erasing the other flash chip, thereby greatly saving the writing operation time and increasing the data write-in speed.

The following specific and detailed description and drawings of the embodiments will help everybody in this field understanding the principal idea of this invention.

### Brief description of drawings

Figure 1 is a schematic diagram showing the distribution of the logical block address corresponding to the physical blocks in the two flash chips in the embodiment of the flash memory data write-in method for the present invention.
Figure 2 is a schematic diagram showing the main process of the flash memory data write-in method for the present invention.
Figure 3 is a schematic diagram showing the first process of the flash memory data write-in method for the present invention.
Figure 4 is a schematic diagram showing the second process of the flash memory data write-in method for the present invention.

### Detailed description

A data write-in method for flash memory is provided to increase the speed of writing data into two or more flash chips. The two flash chips refer to flash chips corresponding to two chip select signals, including a flash chip which is physically one flash chip but contains two chip select signals.

This embodiment is described through the example of writing data into a storage apparatus containing two flash chips. The storage apparatus comprises a controller and two flash chips.

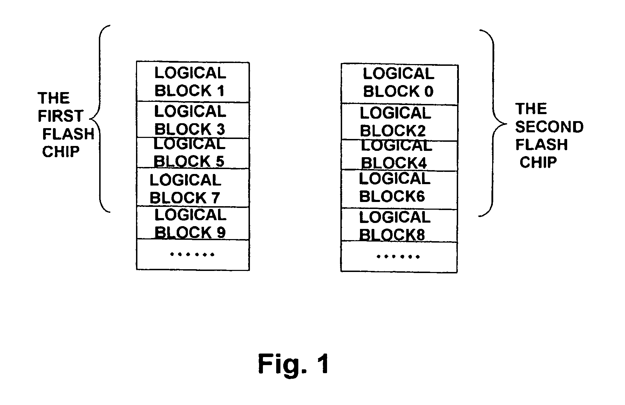

Fig. 1 showed the distribution of the logical block address corresponding to the physical blocks in the two flash chips, which were used in the flash memory data write-in method of the present invention. The physical blocks in the two flash chips were respectively mapped to the odd logical block addresses and the even logical block addresses. The flash chip containing only the odd logical block address was referred to as the first flash chip, while the flash chip containing only the even logical block address was referred to as the second flash chip. The odd logical block addresses of the first flash chip and the even logical block addresses of the second flash chip could be combined into continuous logical block addresses.

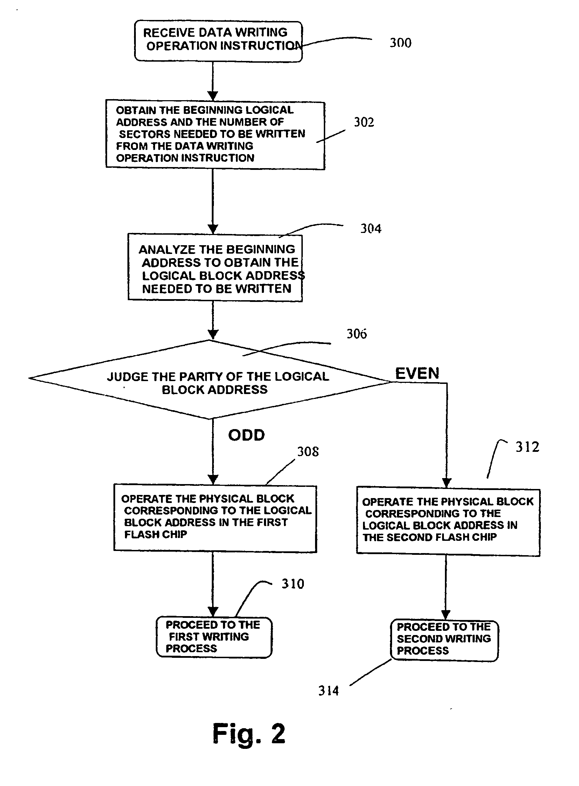

Fig. 2 showed the main process of the present invention. After the data writing operation instruction was received by the controller from the main frame, the following processes took place:
The main process started, i.e. step 300;
The main process then proceeded to step 302 in which the controller obtained the beginning logical address and the number of sectors needed according to the writing operation instruction.

Next, the main process proceeded to step 304 in which the beginning logical address in step 302 was analyzed to obtain the needed logical block address for writing;

Thereafter, the main process proceeded to step 306 in which the parity of the logical block address in step 304 was judged;

If the logical block address was odd, then the main process proceeded to step 308 in which data was written into the physical block corresponding to the logical block address in the first flash chip, then the process proceeded from step 308 to step 310 in which the first writing process was called.

If the logical block address was even, then the main process proceeded to step 312 in which data was written into the physical block corresponding to the logical block address in the second flash chip, then the process proceeded from step 312 to step 314 in which the second writing process was called.

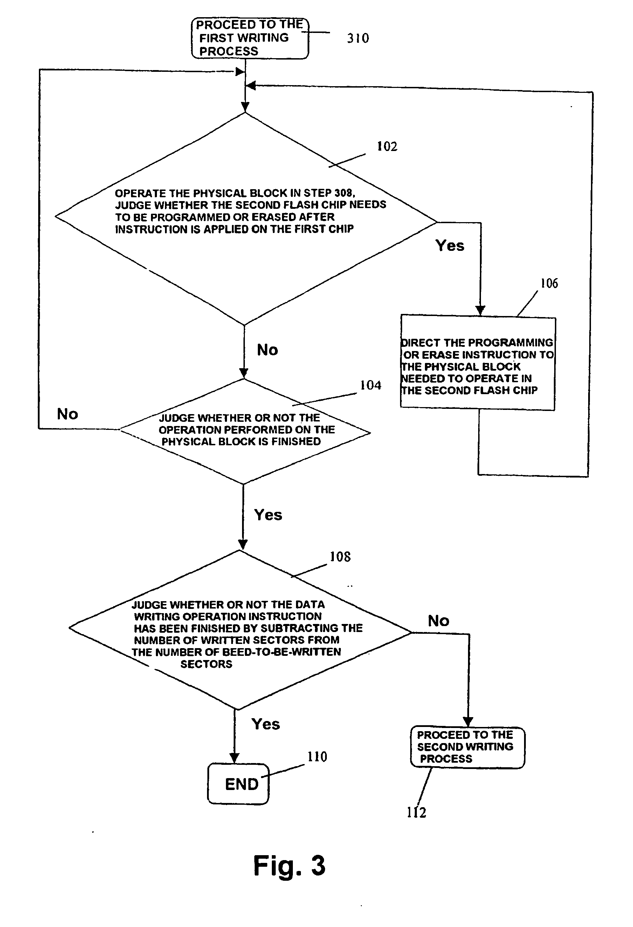

Fig. 3 showed the first process of the flash memory data write-in method for the present invention. The operating process of the present invention proceeded from step 310 of the main process to step 102 of the first writing process.

In step 102, the operations including directing programming and erasing instruction were performed to the physical block in step 308 by the controller. The programming or erase instruction was directed to the physical block until the physical block was to be programmed or erased. Whether the second flash chip needed to be programmed or erased was assessed afterwards.

If the second flash chip needed to be programmed or erased, the first writing process proceeded from step 102 to step 106 in which the controller directed the corresponding instruction to the target physical block on the second flash chip.

If the second flash chip did not need to be erased, the first process proceeded from step 102 to step 104 in which the controller decided whether the operation of the physical block in the first flash chip was finished;

If the operation of the physical block in the first flash chip had not been finished, the first process returned form step 104 to step 102;

If the operation of the physical block in the first flash chip had been finished, the first process proceeded form step 104 to step 108;

In step 108, the controller subtracted the number of the already written sectors from the number of the needed- to-be-written sectors (obtained in step 302), and use the result to decide whether the data writing operation instruction had been finished. If the result was 0, the data writing operation instruction was considered to be finished; if not, the data writing operation instruction was considered to be not finished.

If the data writing operation instruction had been finished, the first process proceeded to step 112 in which the first writing process proceeded to the second writing process.

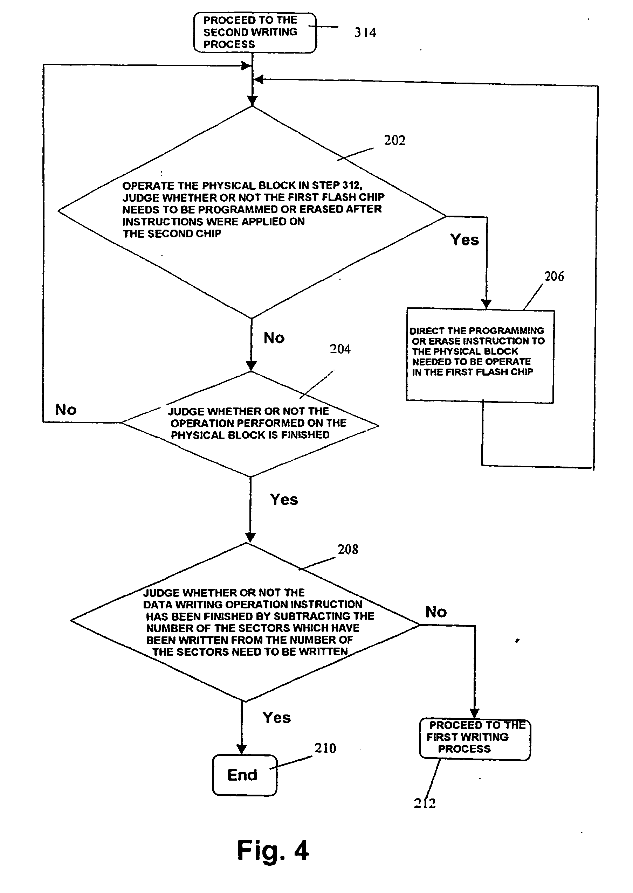

Fig. 4 showed the second process of the method for increasing the data write-in speed of the flash chip in the present invention. The operating process of the present invention proceeded from step 310 of the first writing process to step 202 of the second writing process.

In step 202, the operation was performed to the physical block in step 312 by the controller. The corresponding instruction was directed to the physical block until needed. Whether the first flash chip needed to be programmed or erased was decided afterwards.

If the first flash chip needed to be erased, the first writing process proceeded from step 202 to step 206 in which the needed instruction was directed by the controller to the target physical block of the first flash chip.

If the first flash chip did not need to be erased, the second writing process proceeded from step 202 to step 204 in which the controller decided whether the operation of the physical block in the second flash chip was finished.

If the operation of the physical block in the second flash chip had not been finished, the second writing process returned from step 204 to step 202;

If the operation of the physical block in the second flash chip had been finished, the second writing process proceeded from step 204 to step 208;

In step 208, the controller subtracted the number of the written sectors from the number of the need-to-be- written sectors (obtained in step 302), and decided according to the result whether the data writing operation instruction had been finished. If the result was 0, the data writing operation instruction was decided to have been finished; if not, the data writing operation instruction was decided to have not been finished.

If the data writing operation instruction had been finished, the second writing process proceeded to step 210 which was the end of the whole process.

If the data writing operation instruction has not been finished, the second writing process proceeded to step 212 in which the said first writing process was called.

When multiple flash chips were included in the flash memory apparatus, the physical blocks in each of two flash chips corresponded respectively to odd logical block addresses and even logical block addresses, and the data write-in operation was performed in the unit of two flash chips. The data write-in operating method performed in the two flash chips was the same as the method of the above embodiment.

The description above was merely the preferred embodiment of the present invention. It should be noted that various improvements and modifications could be made without departing from the principle of the present invention. All these improvements and modifications should also be regarded as the protection scope of the present invention.

## Claims

1. A data write-in method for flash memory, wherein the flash memory comprises two flash chips, and the method includes:
a. partitioning the physical blocks in the one chip of the two flash chips to odd logical block addresses and those of the other chip to even logical block addresses;
b. receiving a data write-in instruction (300) and analyzing the beginning logical address corresponding to the writing operation from the data write-in instruction (302);
c. obtaining according to the beginning logical address the logical block address needed to be written (304), deciding the parity of the logical block address needed to be written (306), and selecting the corresponding flash chip between the two flash chips according to the parity of the logical block address needed to be written (308, 312);
d. detecting whether the other flash chip needs to be programmed or erased after the programming or erase instruction is directed to the physical block corresponding to the logical block address in the corresponding flash chip (102, 202).

2. The data write-in method for flash memory according to claim 1, wherein it further comprises the following step:
e. if the other flash chip needs to be programmed or erased, directing programming or erase instruction to the other flash chip (106, 206).

3. The data write-in method for flash memory according to claim 1, wherein it further comprises the following step:
f. if the other flash chip do not need to be programmed or erased, then judge whether the operation performed to the corresponding physical block in step d is finished (104, 204).

4. The data write-in method for flash memory according to claim 3, wherein it further comprises: if the operation performed on the corresponding physical block has been finished (108, 208), judge whether the data write-in instruction has been finished; if the operation performed to the corresponding physical block has not been finished, return to step d (112, 212).

5. The data write-in method for flash memory according to claim 3, wherein that: if the data write-in instruction has been finished, return to step b; if the data write-in instruction has not been finished, return to step c.

6. The data write-in method for flash memory according to claim 4, wherein that: the step b further comprises obtaining the number of sectors needed to be written from the data writing operation instruction (302).

7. The data write-in method for flash memory according to claim 6, wherein that: the method further comprises judging whether the data writing operation instruction has been finished by subtracting the number of written sectors from the number of need-to-be-written sectors (108, 208).

## Patentansprüche

1. Dateneinschreibeverfahren für einen Flash-Speicher, wobei der Flash-Speicher zwei Flash-Chips umfasst, und wobei das Verfahren folgendes aufweist:
a.) das Partitionieren der physischen Blöcke in dem einen Chip der zwei Flash-Chips in ungerade logische Blockadressen, und der in dem anderen Chip in gerade logische Blockadressen;
b.) das Empfangen eines Dateneinschreibebefehls (300) und das Analysieren der logischen Ausgangsadresse, die der Schreiboperation durch den Dateneinschreibebefehls (302) entspricht;
c.) das Erhalten der zu schreibenden (304) logischen Blockadresse anhand der logischen Ausgangsadresse, wobei die Parität der logischen Blockadresse festgelegt wird, die geschrieben werden muss (306), und wobei aus den beiden Flash-Chips der entsprechende Flash-Chip gemäß der Parität der logischen Blockadresse ausgewählt wird, die geschrieben werden muss (308, 312);
d.) das Detektieren, ob der andere Flash-Chip programmiert oder gelöscht werden muss, nachdem der Programmierungs- oder Löschbefehl auf den physischen Block gerichtet worden ist, der der logischen Blockadresse in dem entsprechenden Flash-Chip (102, 202) entspricht.

2. Dateneinschreibeverfahren für einen Flash-Speicher nach Anspruch 1, wobei das Verfahren ferner den folgenden Schritt umfasst:
e.) wenn der andere Flash-Chip programmiert oder gelöscht werden muss, das Richten des Programmierungs- oder Löschungsbefehls an den anderen Flash-Chip (106, 206).

3. Dateneinschreibeverfahren für einen Flash-Speicher nach Anspruch 1, wobei das Verfahren ferner den folgenden Schritt umfasst:
f.) wenn der andere Flash-Chip nicht programmiert oder gelöscht werden muss, das Beurteilen, ob die an dem entsprechenden physischen Block in Schritt d) ausgeführte Operation abgeschlossen ist (104, 204).

4. Dateneinschreibeverfahren für einen Flash-Speicher nach Anspruch 3, wobei das Verfahren ferner folgendes umfasst: wenn die an dem entsprechenden physischen Block ausgeführte Operation abgeschlossen ist (108, 208), das Beurteilen, ob der Dateneinschreibebefehl abgeschlossen ist; wenn die an dem entsprechenden physischen Block ausgeführte Operation nicht abgeschlossen ist, das Zurückkehren zu dem Schritt d) (112, 212).

5. Dateneinschreibeverfahren für einen Flash-Speicher nach Anspruch 3, wobei: wenn der Dateneinschreibebefehl abgeschlossen ist, zu dem Schritt b) zurückgekehrt wird; und wobei, wenn der Dateneinschreibebefehl noch nicht abgeschlossen ist, zu dem Schritt c) zurückgekehrt wird.

6. Dateneinschreibeverfahren für einen Flash-Speicher nach Anspruch 4, wobei: der Schritt b) ferner das Erhalten der Anzahl von Sektoren umfasst, die durch den Dateneinschreibeoperationsbefehl (302) geschrieben werden müssen.

7. Dateneinschreibeverfahren für einen Flash-Speicher nach Anspruch 6, wobei: das Verfahren ferner as Beurteilen umfasst, ob der Dateneinschreibebefehl abgeschlossen ist, indem die Anzahl der beschriebenen Sektoren von der Anzahl der zu beschreibenden Sektoren (108, 208) subtrahiert wird.

## Revendications

1. Procédé d'enregistrement de données dans une mémoire flash, où la mémoire flash comprend deux puces flash, et le procédé comprend les étapes consistant à:
a. partitionner les blocs physiques dans l'une des deux puces flash vers des adresses de bloc logique impaires et ceux de l'autre puce vers des adresses de bloc logique paires,
b. recevoir une instruction d'enregistrement de données (300) et analyser l'adresse logique initiale correspondant à l'opération d'écriture de l'instruction d'enregistrement de données (302),
c. obtenir selon l'adresse logique initiale l'adresse bloc logique devant être écrite (304), décider la parité de l'adresse bloc logique devant être écrite (306) et sélectionner la puce flash correspondante parmi les deux puces flash en accord avec la parité de l'adresse bloc logique devant être écrite (308, 312);
d. détecter si l'autre puce flash doit être programmée ou effacée après que l'instruction de programmation ou d'effacement a été dirigée vers le bloc physique correspondant à l'adresse bloc logique dans la puce flash correspondante (102, 202).

2. Procédé d'enregistrement de données dans une mémoire flash selon la revendication 1, où il comprend en outre l'étape consistant à:
e. si l'autre puce flash doit être programmée ou effacée, diriger l'instruction de programmation ou d'effacement à l'autre puce flash (106, 206).

3. Procédé d'enregistrement de données dans une mémoire flash selon la revendication 1, où 11 comprend en outre l'étape suivante:
f. si l'autre puce flash n'a pas besoin d'être programmée ou effacée, établir si l'opération exécutée vers le bloc physique correspondant à l'étape d est terminée (104, 204).

4. Procédé d'enregistrement de données dans une mémoire flash selon la revendication 3, où il comprend en outre: si l'opération exécutée sur le bloc physique correspondant est terminée (108, 208), établir si l'instruction d'enregistrement de données est terminée; si l'opération exécutée vers le bloc physique correspondant n'est pas terminée, revenir à l'étape d (112, 212).

5. Procédé d'enregistrement de données dans une mémoire flash selon la revendication 3, dans lequel: si l'instruction d'enregistrement de données est terminée, revenir à l'étape b; si l'instruction d'enregistrement de données n'est pas terminée, revenir à l'étape c.

6. Procédé d'enregistrement de données dans une mémoire flash selon la revendication 4, où: l'étape b comprend en outre l'obtention du nombre de secteurs devant être écrits suite à l'instruction d'opération d'enregistrement de données (302).

7. Procédé d'enregistrement de données dans une mémoire flash selon la revendication 6, où: le procédé comprend en outre l'établissement si l'opération d'enregistrement de données a été finie en déduisant le nombre de secteurs écrits du nombre des secteurs devant être écrits (108, 208).
